# DEMANDE DE BREVET EUROPEEN

(11) **EP 2 363 879 A2**
(43) Date de publication de la demande: **07.09.2011**
(21) Numéro de dépôt: 11151327.1
(22) Date de dépôt: 18.01.2011
(51) Int. Cl.: H01L 21/762

(54) **Procédé de réalisation d'une structure multicouche avec détourage par effets thermomécaniques**

(30) Priorité: 02.03.2010 FR 1051487
(71) Demandeur: S.O.I. Tec Silicon on Insulator Technologies, 38190 Bernin (FR)
(72) Inventeur: Vaufredaz, Alexandre, 38140, La Murette (FR); Molinari, Sébastien, 38360, Sassenage (FR)
(74) Mandataire: Desormiere, Pierre-Louis

(57) **Abrégé**

L'invention concerne un procédé de réalisation d'une structure multicouche (130) comprenant:
- le collage (S1) d'une première plaque (110) sur une deuxième plaque (120), au moins la première plaque présentant un bord chanfreiné (117a, 117b), l'interface de collage présentant une énergie d'adhésion inférieure ou égale à 1 J/m²,
- l'amincissement (S3, S4) de la première plaque (110) pour former une couche transférée (115).

Avant l'amincissement de la première plaque (110), une étape de détourage du bord de la première plaque (110) est réalisée avec une roue (150) dont la surface de travail (151) comprend des particules abrasives d'une taille moyenne supérieure ou égale à 800 mesh ou inférieure ou égale à 18 microns, ladite étape de détourage étant réalisée avec une vitesse de descente de la roue supérieure ou égale à 5 micromètres par seconde, la descente de la roue dans la première plaque étant en outre stoppée à une hauteur (h₁₁₀) de l'interface de collage inférieure ou égale 30 µm.

## Description

La présente invention se rapporte au domaine de la réalisation des structures ou substrats semi-conducteurs multicouches (également dénommées "multilayer semiconductor wafers") réalisés par transfert d'au moins une couche sur un support.

La réalisation de structures multicouches comprend en général le collage par adhésion moléculaire (en anglais "direct wafer bonding" ou "fusion bonding") d'une première plaque, par exemple une plaque de silicium ou de type SOI (Silicium sur Isolant), sur une deuxième plaque ou support par exemple en silicium ou en saphir, un recuit de renforcement de collage, et un amincissement de la première plaque pour former une couche transférée sur la deuxième plaque.

L'invention concerne plus particulièrement les structures multicouches ayant une interface de collage relativement faible en raison de la limitation en température du recuit de renforcement de collage. Après un collage par adhésion moléculaire, on procède habituellement à un recuit de la structure afin de renforcer le collage entre les deux plaques, c'est-à-dire augmenter l'énergie de surface du collage entre celles-ci. Plus la température du recuit de renforcement de collage est élevée, plus l'énergie de collage ou d'adhésion résultante est grande.

Or, il existe plusieurs cas de structures multicouches dans lesquels la température du recuit de collage doit être limitée à des valeurs relativement basses.

Un premier cas concerne la réalisation de structures multicouches dites "hétérogènes" en ce que les deux plaques à assembler présentent des coefficients de dilatation thermique différents, par exemple différents d'au moins 10% ou 20% à température ambiante (20°C). De telles hétérostructures sont notamment celles du type silicium sur saphir (AL₂O₃) connues sous l'acronyme SOS (pour "Silicon-On-Sapphire") et sont utilisées notamment en microélectronique ou en optoélectronique. Lors de montées en température, par exemple à partir de 200°C et au-delà, les variations de comportement d'une des deux plaques par rapport à l'autre engendrent des contraintes et/ou des déformations dans l'hétérostructure qui peuvent entraîner la délamination ou le détachement des plaques ou couches en présence, et/ou des déformations plastiques et/ou des fractures et/ou une cassure de l'un ou des substrats ou couches en présence. C'est pourquoi, avec de telles structures, la température du recuit de renforcement de collage est limitée.

Un deuxième cas concerne les structures multicouches dans lesquelles la première plaque comprend en outre tout ou partie d'un composant ou d'une pluralité de microcomposants comme c'est le cas dans la technologie d'intégration tridimensionnelle de composants (3D-integration) qui nécessite le transfert d'une ou plusieurs couches de microcomposants sur un support final mais aussi dans le cas de transfert de circuits comme, par exemple, dans la fabrication d'imageurs éclairés en face arrière. Dans ce cas, la température du recuit de renforcement de collage doit être limitée pour ne pas endommager les microcomposants.

Les bords des plaques utilisées pour former notamment les couches transférées et les supports présentent généralement des chanfreins ou tombées de bord (également connus sous les termes anglais de "edge rounding") dont le rôle est de faciliter leur manipulation et d'éviter les bris de bords qui pourraient se produire si ces bords étaient saillants, de tels bris étant sources de contamination en particules des surfaces des plaques. Les chanfreins peuvent être de forme arrondie et/ou biseautée.

Cependant, la présence de ces chanfreins empêche un bon contact entre les plaques au niveau de leur périphérie, cette faiblesse d'adhésion étant encore plus prononcée lorsque l'interface de collage est faible en raison de la limitation de la température du recuit de renforcement tel que décrit ci-avant. Par conséquent, il existe une zone périphérique sur laquelle la première plaque ou couche transférée est peu ou pas collée. Cette zone périphérique de la première plaque ou couche transférée doit être éliminée car elle est susceptible de se casser de façon non contrôlée et de contaminer la structure par des fragments ou particules indésirables.

A cet effet, une fois la plaque collée sur le support et après amincissement de celle-ci, on procède à un détourage de la couche transférée afin de retirer la zone périphérique sur laquelle s'étendent les chanfreins. Le détourage est habituellement réalisé par usinage mécanique notamment par abrasion à partir de la surface exposée de la couche transférée et jusque dans la deuxième plaque support.

Cependant, un détourage mécanique profond entraîne des problèmes d'écaillage (en anglais "peel off") aussi bien au niveau de l'interface de collage entre la couche transférée et le support que dans la couche transférée elle-même. Plus précisément, au niveau de l'interface de collage, les problèmes d'écaillage correspondent à une délamination de la couche transférée sur certaines zones au voisinage de la périphérie de la couche qui peut être qualifiée de macro écaillage (ou "macro peel off"). L'énergie de collage est plus faible au voisinage de la périphérie de la couche en raison de la présence des chanfreins. Par conséquent, ce détourage peut entraîner à cet endroit un décollement partiel de la couche au niveau de son interface de collage avec le substrat support.

Il se pose, par conséquent, le problème de trouver un procédé permettant de détourer la première plaque ou couche transférée dans une structure multicouche et qui n'entraîne pas les inconvénients mentionnés ci-dessus.

### Résumé de l'invention

L'invention a pour but de remédier aux inconvénients précités en proposant un procédé de réalisation d'une structure multicouche comprenant:
- le collage d'une première plaque sur une deuxième plaque, au moins la première plaque présentant un bord chanfreiné, l'interface de collage présentant une énergie de surface du collage, ou énergie de collage, inférieure ou égale à 1 J/m²,
- l'amincissement de la première plaque pour former une couche transférée,
procédé dans lequel, avant l'amincissement de la première plaque, on réalise une étape de détourage du bord de la première plaque avec une roue dont la surface de travail comprend des particules abrasives d'une taille moyenne inférieure ou égale à 18 microns ou supérieure ou égale à 800 mesh, ladite étape de détourage étant réalisée avec une vitesse de descente de la roue supérieure ou égale à 5 micromètres par seconde, la descente de la roue dans la première plaque étant en outre stoppée à une hauteur de l'interface de collage inférieure ou égale 30 µm.

En réalisant le détourage de la première plaque avant son amincissement et dans les conditions opératoires définies ci-dessus, il possible d'obtenir un détourage complet de la première plaque tout en limitant la profondeur de pénétration de la roue dans la première plaque à une profondeur inférieure à la hauteur totale de la portion de la première plaque à détourer (arrêt de la descente de la roue dans la première plaque au-dessus de l'interface de collage). On évite ainsi les problèmes d'écaillage mentionnés ci-avant.

Selon un aspect de l'invention, l'étape de détourage est réalisée sur une largeur au moins égale à largeur sur laquelle s'étend le bord chanfreiné.

Selon un mode mise en oeuvre particulier de l'invention, le procédé comprend, avant l'étape de collage, au moins une étape de réalisation d'une couche de composants sur une face de la première plaque, la face de la première plaque comportant la couche de composants étant collée sur la deuxième plaque. Une étape de réalisation d'une deuxième couche de microcomposants sur la face de la première plaque opposée à la face comportant la première couche de composants peut être en outre réalisée.

L'utilisation du procédé de détourage de l'invention permet de réaliser des structures tridimensionnelles par empilement de deux plaques ou plus en minimisant les risques de délamination à la fois au niveau des interfaces de collage entre les plaques et au niveau des couches de composants. Une des couches de composants peut notamment comporter des capteurs d'images.

### Brève description des figures

D'autres caractéristiques et avantages de l'invention ressortiront de la description suivante de modes particuliers de réalisation de l'invention, donnés à titre d'exemples non limitatifs, en référence aux dessins annexés, sur lesquels :
- les figures 1A à 1E sont des vues schématiques d'un procédé de réalisation d'une structure multicouche conformément à un mode de réalisation de l'invention,
- la figure 2 est un organigramme des étapes mises en oeuvre lors du procédé illustré dans les figures 1A à 1E,
- les figures 3A à 3G, sont des vues schématiques montrant la réalisation d'une structure tridimensionnelle mettant en oeuvre le procédé de détourage de la présente invention,
- la figure 4 est un organigramme des étapes mises en oeuvre lors de la réalisation de la structure tridimensionnelle illustrée dans les figures 3A à 3G.

### Exposé détaillé de modes de réalisation de l'invention

La présente invention s'applique, d'une manière générale, au détourage d'une structure multicouche comprenant au moins deux plaques assemblées entre elles par collage et pour lesquelles l'énergie de surface du collage est limitée à une valeur inférieure ou égale à 1 J/m², au moins une des deux plaques comportant des chanfreins ou tombées de bords à sa périphérie. De telles structures multicouches correspondent notamment aux structures réalisées à partir d'au moins deux plaques ayant des coefficients de dilatation thermique différents ou comprenant des microcomposants et pour lesquelles la température du recuit de renforcement de collage permettant de stabiliser ce denier et d'augmenter son énergie doit être limitée. L'invention pourrait s'appliquer également à des structures multicouches dans lesquelles les plaques sont assemblées entre elles par d'autre type de collage tel que le collage anodique, métallique, ou avec adhésif, dans la mesure où l'énergie de collage reste inférieure à 1 J/m².

Les plaques se présentent sous la forme de tranches ou "wafers" au contour généralement circulaire et peuvent présenter différents diamètres, notamment des diamètres de 100 mm, 150mm, 200 mm ou 300 mm.

Des composants peuvent être préalablement formés dans une des plaques qui est ensuite collée sur l'autre plaque qui constitue un support. On entend ici par "composants" tout type d'éléments réalisés avec des matériaux différents de celui de la plaque et qui sont sensibles aux hautes températures habituellement utilisées pour renforcer l'interface de collage. Ces composants correspondent notamment à des éléments formant tout ou partie d'un composant électronique ou d'une pluralité de microcomposants électroniques, tels que des circuits ou des contacts ou encore des couches actives.

L'invention s'applique plus particulièrement, mais non exclusivement, à des hétérostructures de type SOS (silicium sur saphir) formée à partir d'un assemblage entre une première plaque ou substrat de saphir et une deuxième plaque ou substrat comprenant du silicium tel qu'une structure SOI. Les hétérostructures comprenant une couche de silicium sur un substrat saphir présentent des avantages particuliers. Les structures SOS permettent la réalisation de dispositifs hautes fréquences à faible consommation d'énergie. L'utilisation de substrats en saphir permet en outre d'avoir une très bonne dissipation thermique supérieure à celle obtenue par exemple avec des substrats en quartz.

La présente invention propose de réaliser un détourage dans lequel on attaque la première plaque sur une profondeur inférieure à l'épaisseur totale de ladite plaque, mais dans des conditions spécifiques permettant de créer des effets thermomécaniques tels qu'ils conduisent à l'arrachement de la portion restante de la première plaque à détourer, c'est-à-dire la portion de la première plaque située au-dessus de l'interface de collage dans laquelle la roue n'a pas pénétrée. En stoppant ainsi la descente de l'outil avant que ce dernier atteigne l'interface de collage entre les première et deuxième plaques, on évite les problèmes d'écaillage et de décollement décrits ci-avant.

Plus précisément, dans la présente invention, le détourage est réalisé avec une roue ou meule dont la surface de travail ou partie active comporte des particules abrasives d'une taille moyenne inférieure ou égale à 18 microns ou supérieure ou égale à 800 mesh. Les particules abrasives peuvent être notamment des particules de diamant.

En outre, la vitesse de descente, encore appelée vitesse d'avance, de la roue est supérieure ou égale à 5 µm/s.

L'ajustement de ces deux paramètres permet de maximiser les effets thermiques et mécaniques du détourage sur la première plaque, en particulier en fin de détourage, ce qui permet de fragiliser mécaniquement la couronne ou portion de la première plaque subsistant en dessous de la roue en y créant notamment des fissures et de faciliter, par conséquent, son arrachement. Ces effets sont d'autant plus importants que, dans l'invention, le détourage est réalisé avant l'amincissement de la première plaque de sorte qu'une quantité de matière importante est retirée lors du détourage, ce qui permet d'obtenir en fin de détourage des effets thermomécaniques importants.

Contrairement à l'art antérieur où la roue descend au moins jusqu'à l'interface de collage lors du détourage de la première plaque, dans la présente invention, la roue est stoppée à une hauteur déterminée au-dessus de l'interface de collage. Plus précisément, la profondeur de pénétration de la roue dans la première plaque, également appelée "visée", est réglée de manière à stopper la descente de la roue dans la première plaque à une distance inférieure à 30 µm de l'interface de collage, de préférence à une distance inférieure à 20 µm. D'une manière générale, la descente de la roue est stoppée à une hauteur comprise entre 30 µm et 10 µm de l'interface de collage

La maximisation des effets thermomécaniques lors du détourage comme expliqué ci-dessus et la faiblesse de l'interface de collage entre les deux couches permettent d'obtenir un détourage complet de la première plaque par arrachement de la portion restante à détourer bien que la première plaque ne soit pas attaquée par la roue sur toute son épaisseur.

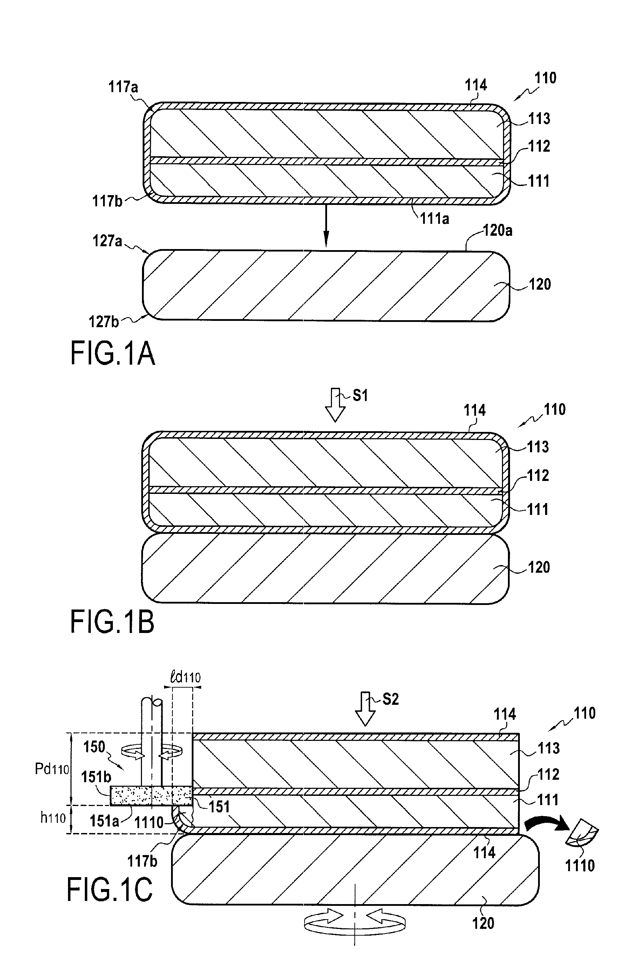

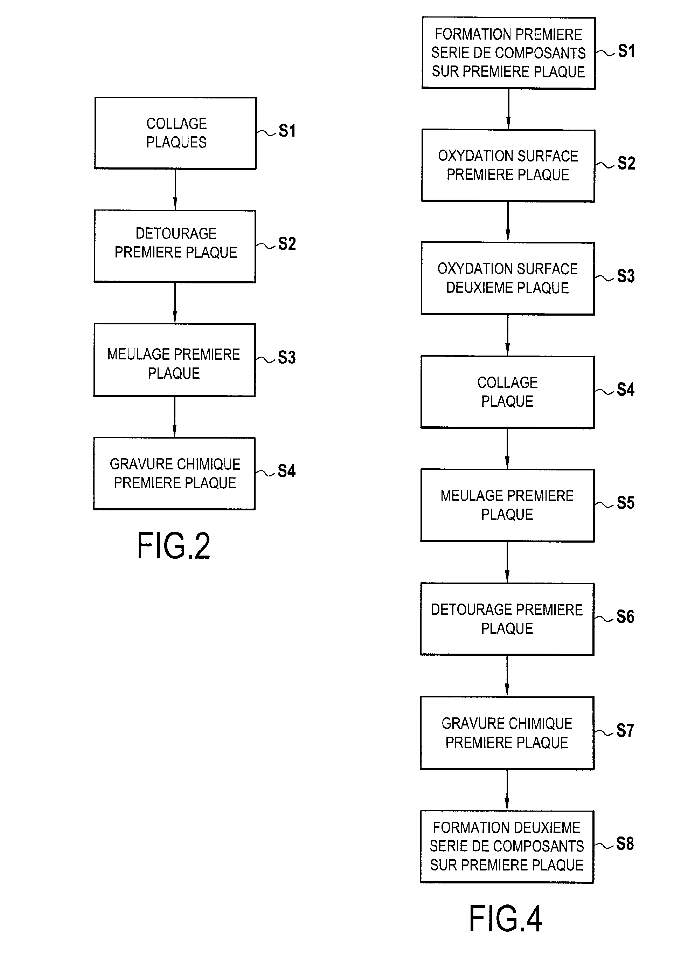

Un mode de mise en oeuvre d'un procédé de détourage va maintenant être décrit en relation avec les figures 1A à 1E et 2.

On décrit, en référence aux figures 1A à 1E et 2, un procédé de réalisation d'une hétérostructure de type SOS à partir d'une première plaque ou substrat initial 110 (Top) et d'une deuxième plaque ou substrat support 120 (Base). La première plaque 110 comporte à sa périphérie un chanfrein supérieur 117a et un chanfrein inférieur 117b. De même, la deuxième plaque 120 comporte à sa périphérie un chanfrein supérieur 127a et un chanfrein inférieur 127b. La première plaque 110 a une épaisseur comprise entre 600 et 900 µm environ.

Comme représentée sur la figure 1A, la première plaque 110 est constituée d'une structure de type SOI (Silicium sur Isolant) comprenant une couche de silicium 111 sur un support 113 également en silicium, une couche d'oxyde enterrée 112, par exemple en SiO₂, étant disposée entre la couche 111 et le support 113. La surface extérieure de la première plaque 110 a été en outre préalablement recouverte d'une couche d'oxyde thermique 114 ayant une épaisseur comprise entre 10 et 50 nm et formée par exemple par oxydation de la surface de la plaque, afin de protéger cette dernière lors de l'étape de gravure chimique ultérieure. La première plaque 110 peut être également constituée d'une plaque de silicium monolithique comportant ou non des composants.

La deuxième plaque 120 est constituée d'une plaque ("wafer") de saphir (figure 1A).

La face 111a (ici recouverte de la couche d'oxyde 114) de la première plaque 110 et la surface 120a de la deuxième plaque 120 sont mises en contact intime et une pression est appliquée sur l'une des deux plaques afin d'initier la propagation d'une onde de collage entre les surfaces en contact (étape S1, figure 1B).

Comme bien connu en soi, le principe du collage par adhésion moléculaire, encore appelé collage direct, est basé sur la mise en contact direct de deux surfaces, c'est-à-dire sans l'utilisation d'un matériau spécifique (colle, cire, brasure, etc.). Une telle opération nécessite que les surfaces à coller soient suffisamment lisses, exemptes de particules ou de contamination, et qu'elles soient suffisamment rapprochées pour permettre d'initier un contact, typiquement à une distance inférieure à quelques nanomètres. Dans ce cas, les forces attractives entre les deux surfaces sont assez élevées pour provoquer l'adhérence moléculaire (collage induit par l'ensemble des forces attractives (forces de Van Der Waals) d'interaction électronique entre atomes ou molécules des deux surfaces à coller).

Le collage ainsi réalisé n'est pas stabilisé en ce qu'un recuit de renforcement de collage n'a pas été réalisé. Il est possible de soumettre l'assemblage des deux plaques à un recuit mais dont la température doit être nécessairement limitée en raison de la différence de coefficient de dilatation thermique entre les deux plaques. Dans l'exemple décrit ici, le recuit ne peut dépasser 180°C, et ce sur une durée inférieure à une dizaine d'heures. Un tel recuit ne permet de stabiliser le collage si bien que l'énergie de surface du collage n'excède pas 700 MJ/M².

Conformément à l'invention, avant l'amincissement de la première plaque 110, on procède à un détourage de cette dernière (étape S2, figure 1C).

Comme illustré sur la figure 1C, le détourage est réalisé sur une largeur Id₁₁₀ à partir du bord de la première plaque 110, cette largeur correspondant au moins à la largeur sur laquelle s'étend le chanfrein inférieur 117b de la première plaque. Pour des plaques d'un diamètre de 100 mm, 200 mm, et 300 mm, la largeur Id₁₁₀ du détourage est en général comprise entre 2 mm et 10 mm, préférentiellement entre 2 mm et 6 mm.

Le détourage est réalisé par action ou usinage mécanique à partir de la face supérieure de la première plaque 110 (en anglais "edge grinding"). L'action mécanique peut être exercée par une meule (abrasion) ou tout autre outil apte à user mécaniquement le matériau de la couche.

Dans l'exemple décrit ici, le détourage est réalisé au moyen d'une roue 150 qui présente une surface de travail ou partie active 151, c'est-à-dire la surface qui comprend des particules abrasives aptes à attaquer le matériau de la plaque, formée d'une première portion 151a parallèle au plan de la plaque et d'une deuxième portion 151b correspondant au flanc de la roue 150. Conformément à l'invention, la surface de travail 151 de la roue 150 comporte des particules abrasives, telles que des particules de diamant, d'une taille moyenne inférieure ou égale à 18 microns (ou supérieure ou égale 800 mesh).

Lors du détourage, la première plaque 110 est attaquée sur une profondeur de descente de la roue 150 Pd₁₁₀ (visée), définie en fonction d'une hauteur h₁₁₀ déterminée par rapport à un plan de référence correspondant à l'interface de collage (ici le plan de contact entre la couche d'oxyde thermique 114 et la face de collage 120a de la deuxième plaque 120). La profondeur Pd₁₁₀ est choisie de manière à pénétrer avec la roue dans la première plaque seulement sur une partie de l'épaisseur de cette dernière. Dans l'exemple, décrit ici, la profondeur de détourage Pd₁₁₀ est choisie de manière à stopper la descente de la roue 150 à une hauteur de l'interface de collage h₁₁₀ comprise entre 30 µm et 10 µm, hauteur à partir de laquelle la portion annulaire ou couronne 1110 subsistant sous la roue 150 s'arrache sous les effets thermomécaniques. On obtient ainsi un détourage complet de la première plaque 110.

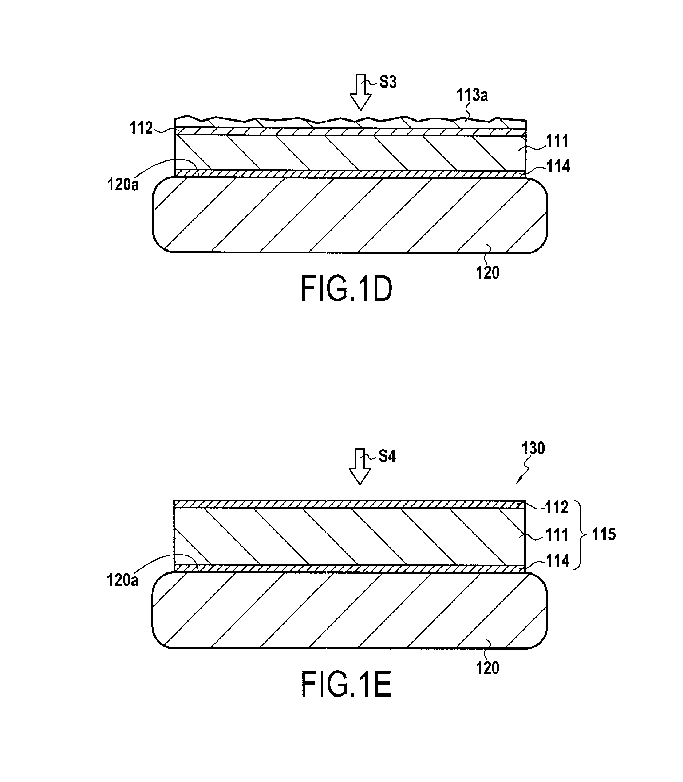

La réalisation de l'hétérostructure se poursuit par l'amincissement de la première plaque 110 de manière à former une couche transférée correspondant à une portion de ladite première plaque détourée. L'amincissement est réalisé d'abord par meulage d'une portion majoritaire du support 113 de la première plaque 110 (étape S3, figure 1D). Le meulage est réalisé en maintenant la surface de travail d'une roue ou meule contre la face exposée de la première plaque 110 (non représentée sur la figure 1D). Lors du meulage, l'assemblage des deux plaques est maintenu au niveau de la face arrière de la deuxième plaque 120 par un support (non représentée sur la figure 1D), également appelé "chuck", comportant un plateau apte à maintenir la deuxième plaque 120, par exemple, par succion ou par un système électrostatique. Durant le meulage, le support peut être fixe tandis que la roue est entraînée en rotation. Alternativement, le support peut être aussi mobile en rotation autour d'un axe, la roue étant entraînée ou non en rotation.

Le meulage est stoppé à environ 65 µm de la surface 120a du substrat support en saphir.

A ce stade de l'amincissement, c'est-à-dire avant la deuxième étape de l'amincissement réalisée par voie chimique, la partie restante 113a du support 113 de la première plaque 110 présente une surface écrouie (figure 1C).

L'amincissement de la première plaque 110 est poursuivi par une gravure chimique, encore appelée gravure humide, de la portion restante 113a (étape S4, figure 1E) par exemple, au moyen d'une solution de gravure TMAH (Tetramethylammonium hydroxide), KOH, gravure sèche de type RIE (pour "Reactive Ion Etching").

En outre du retrait de la portion restante 113a, la gravure chimique a pour effet d'éliminer les éventuels fragments de portion annulaire 1110 qui pourraient subsister après l'arrachement de celle-ci.

Après la gravure, on obtient ainsi une structure multicouche 130 de type SOS comprenant un support en saphir formé par la deuxième plaque 120 et une couche transférée 115 correspondant au moins à la couche de silicium 111 de la première plaque 110, la couche d'oxyde 112 pouvant être, suivant les besoins, conservée ou retirée, par exemple par désoxydation HF.

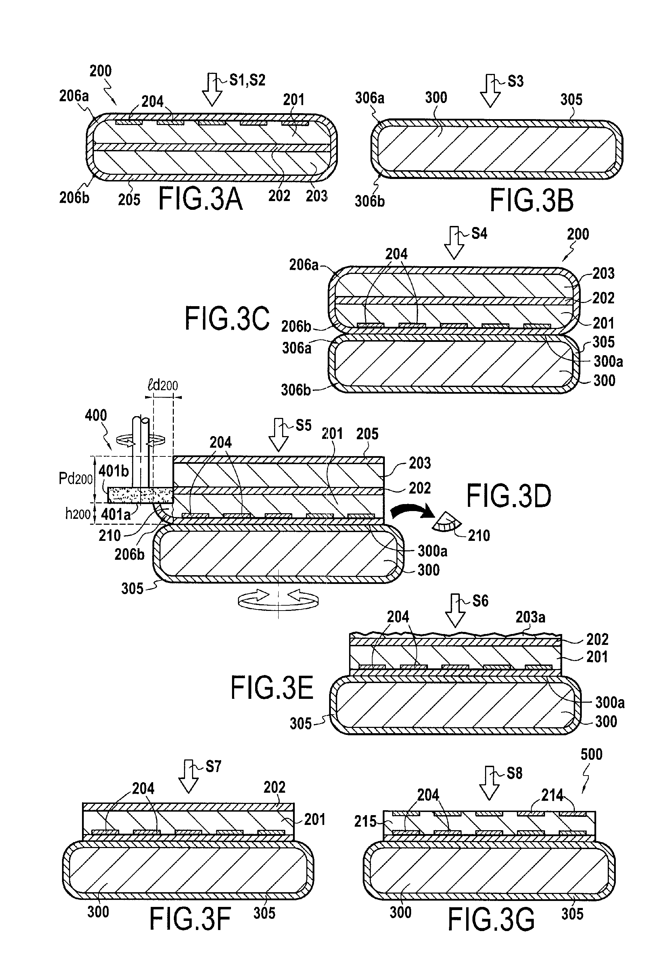

Un procédé de réalisation d'une structure tridimensionnelle par transfert d'une couche de microcomposants formée dans une première plaque ou un substrat initial 200 sur une deuxième plaque ou substrat support 300 (Base) conformément à un mode de réalisation de l'invention est maintenant décrit en relation avec les figures 3A à 3G et 4.

La réalisation de la structure tridimensionnelle débute par la formation d'une première série de microcomposants 204 à la surface de la première plaque 200 dont le bord périphérique présente un chanfrein supérieur 206a et un chanfrein inférieur 206b (figure 3A, étape S1). Dans l'exemple décrit ici, la première plaque 200 est une structure multicouche de type SOI, c'est-à-dire qui comprend une couche de silicium 201 disposée sur un substrat 203 également en silicium, une couche d'oxyde enterrée 202 (par exemple une couche de SiO₂) étant présente entre la couche 201 et le substrat 203. La première plaque 200 a une épaisseur comprise entre 600 et 900 µm environ.

Les microcomposants 204 sont formés par photolithographie au moyen d'un masque permettant de définir les zones de formation de motifs correspondant aux microcomposants à réaliser.

Comme représentée sur la figure 3A, la surface externe de la première plaque 200 est ensuite recouverte d'une couche d'oxyde thermique 205, ayant une épaisseur comprise par exemple entre 0,1 et 3 µm et formée par exemple par oxydation de la surface de la plaque, afin de protéger cette dernière lors de l'étape de gravure chimique ultérieure (étape S2). La première plaque 200 peut être également constituée d'une plaque de silicium monolithique.

La deuxième plaque ou substrat support 300 est une plaque de silicium dont le bord périphérique présente un chanfrein supérieur 306a et un chanfrein inférieur 206b. La surface externe de la plaque 300 est recouverte d'une couche d'oxyde thermique 305 ayant une épaisseur comprise par exemple entre 0,1 et 3 µm (figure 3B, étape S3).

La face de la première plaque 200 comprenant les microcomposants 204 est ensuite mise en contact intime avec une face de la deuxième plaque 300 via les couches d'oxyde thermique 205 et 305 et une pression est appliquée sur l'une des deux plaques afin d'initier la propagation d'une onde de collage entre les surfaces en contact (étape S4, figure 3C).

L'adhésion entre les deux plaques est réalisée à une température peu élevée pour ne pas endommager les composants et/ou la première plaque. Plus précisément, après la mise en contact des plaques à température ambiante, un recuit de renforcement du collage peut être réalisé mais à une température inférieure à 450°C, température à partir de laquelle certains métaux tels que l'aluminium ou le cuivre commencent à fluer. Un tel recuit ne permet de stabiliser le collage si bien que l'énergie de collage à l'interface de collage n'excède pas 1 J/m².

Conformément à l'invention, après le collage et avant l'amincissement de la première plaque 200, on procède à un détourage de cette dernière (étape S5, figure 3D).

Dans l'exemple décrit ici, le détourage est réalisé au moyen d'une roue 400 qui présente une surface de travail ou partie active 401, c'est-à-dire la surface qui comprend des particules abrasives aptes à attaquer le matériau de la plaque, formée d'une première portion 401a parallèle au plan de la plaque et d'une deuxième portion 401b correspondant au flanc de la roue 400. Comme représentée sur la figure 3D, la portion 401b est ici perpendiculaire à la portion 401a de manière à former un flanc détouré 200c dans la première plaque qui est sensiblement perpendiculaire au plan de la première plaque. Conformément à l'invention, la surface de travail 401 de la roue 400 comporte des particules abrasives, telles que des particules de diamant, d'une taille moyenne inférieure ou égale à 18 microns (ou supérieure ou égale 800 mesh).

Comme illustré sur la figure 3D, le détourage est réalisé sur une largeur minimale Id₂₀₀ à partir du bord de la première plaque 110 qui correspond au moins à la largeur sur laquelle s'étend le chanfrein inférieur 206b de la première plaque. Pour des plaques d'un diamètre de 100 mm, 200 mm, et 300 mm, la largeur Id₂₀₀ du détourage est en général comprise entre 2 mm et 10 mm, préférentiellement entre 2 mm et 6 mm.

Lors du détourage, la première plaque 110 est attaquée sur une profondeur de descente de la roue 400 Pd₂₀₀ (visée), définie en fonction d'une hauteur h₂₀₀ déterminée par rapport à un plan de référence correspondant à l'interface de collage (ici le plan de contact entre les couches d'oxyde thermique 205 et 305). La profondeur Pd₂₀₀ est choisie de manière à pénétrer avec la roue dans la première plaque seulement sur une partie de l'épaisseur de cette dernière. Dans l'exemple, décrit ici, la profondeur de détourage Pd₂₀₀ est choisie de manière à stopper la descente de la roue 40 à une hauteur de l'interface de collage h₂₀₀ comprise entre 30 µm et 15 µm, hauteur à partir de laquelle la portion annulaire ou couronne 210 subsistant sous la roue 400 s'arrache sous les effets thermomécaniques. On obtient ainsi un détourage complet de la première plaque 200.

La réalisation de la structure tridimensionnelle se poursuit par la réalisation de la première étape d'amincissement de la première plaque 200, à savoir le meulage d'une partie de celle-ci présente au-dessus de la couche de microcomposants 204 (étape S6, figure 3E), ici la majeure partie du substrat 203a. Le meulage est réalisé dans les mêmes conditions que décrites précédemment.

Le meulage est stoppé à environ 65 µm de la surface 300a de la deuxième plaque 300.

A ce stade de l'amincissement, c'est-à-dire avant la deuxième étape de l'amincissement réalisée par voie chimique, la partie restante 203a du support 203 de la première plaque 200 présente une surface écrouie (figure 3E).

On poursuit l'amincissement de la première plaque 200 par une gravure chimique de la portion restante 203a (étape S7, figure 3F) par exemple, au moyen d'une solution de gravure TMAH (Tetramethylammonium hydroxide), ou de KOH, ou même d'une gravure sèche de type RIE.

Après avoir préalablement retirée la couche d'oxyde 202, on forme une deuxième couche de microcomposants 214 au niveau de la surface exposée de la couche 201 (figure 3G, étape S8). Dans l'exemple décrit ici, les microcomposants 214 sont formés en alignement avec les microcomposants 204 enterrés. A cet effet, on utilise un masque de photolithographie similaire à celui utilisé pour former les microcomposants 204.

On obtient alors une structure composite 500 formée de la deuxième plaque 300 et d'une couche transférée 215 correspondant à la partie restante de la première plaque 200 comportant les microcomposants 204 et 214.

Dans une variante, la structure tridimensionnelle est formée par un empilement de couches, c'est-à-dire par le collage d'une ou plusieurs plaques ou substrats supplémentaires sur la couche 201, chaque plaque supplémentaire étant en alignement avec la ou les couches directement adjacentes. Un détourage partiel effectué entre les deux étapes d'amincissement conformément à l'invention tel que décrit ci-avant est réalisé pour chaque plaque de manière à former une couche transférée. En outre, avant chaque transfert d'une plaque supplémentaire, on peut déposer sur la couche exposée une couche d'oxyde, par exemple une couche d'oxyde TEOS, afin de faciliter l'assemblage et protéger les zones détourées (pour lesquelles le matériau de la plaque sous-jacente est exposé) des attaques chimiques ultérieures.

Selon un mode de réalisation particulier, une des couches de microcomposants peut notamment comporter des capteurs d'images.

Selon un autre mode de réalisation, des composants ont été préalablement formées dans la deuxième plaque support avant son assemblage avec la première plaque constituant la couche transférée.

## Revendications

1. Procédé de réalisation d'une structure multicouche (130) comprenant:
- le collage d'une première plaque (110) sur une deuxième plaque (120), au moins la première plaque présentant un bord chanfreiné (117a, 117b), l'interface de collage présentant une énergie d'adhésion inférieure ou égale à 1 J/m²,
- l'amincissement de la première plaque (110) pour former une couche transférée (115),
**caractérisé en ce qu'**il comprend, avant l'amincissement de la première plaque (110), une étape de détourage du bord de la première plaque (110) réalisée avec une roue (150) dont la surface de travail (151) comprend des particules abrasives d'une taille moyenne supérieure ou égale à 800 mesh ou inférieure ou égale à 18 microns, ladite étape de détourage étant réalisée avec une vitesse de descente de la roue supérieure ou égale à 5 micromètres par seconde, la descente de la roue dans la première plaque étant en outre stoppée à une hauteur (h₁₁₀) de l'interface de collage inférieure ou égale 30 µm.

2. Procédé selon la revendication 1, **caractérisé en ce que** l'étape de détourage est réalisée sur une largeur (Id₁₁₀) au moins égale à largeur sur laquelle s'étend le bord chanfreiné (117a, 117b).

3. Procédé selon la revendication 2, caractérisé en ce l'étape de détourage est réalisée sur une largeur (Id₁₁₀) comprise entre 2 mm et 8 mm.

4. Procédé selon l'une quelconque des revendications 1 à 3, **caractérisé en ce que** la première plaque (110) présente une épaisseur avant amincissement d'au moins 600 µm.

5. Procédé selon l'une quelconque des revendications 1 à 4, **caractérisé en ce que** l'amincissement comprend une étape de meulage.

6. Procédé selon l'une quelconque des revendications 1 à 5, **caractérisé en ce que** la première plaque (110) est une plaque de silicium ou une structure du type SOI.

7. Procédé selon la revendication 6, **caractérisé en ce que** l'amincissement comprend en outre une étape de gravure chimique réalisée après l'étape de meulage.

8. Procédé selon la revendication 6 ou 7, **caractérisé en ce que**, avant l'étape de collage, on forme une couche d'oxyde (114) sur la surface exposée de la première plaque (110).

9. Procédé selon l'une quelconque des revendications 1 à 8, **caractérisé en ce que** la première plaque (110) comprend des composants.

10. Procédé selon l'une quelconque des revendications 1 à 9, **caractérisé en ce que** la deuxième plaque (120) est une plaque de saphir.

11. Procédé selon l'une quelconque des revendications 1 à 9, **caractérisé en ce que** la deuxième plaque (120) est une plaque de silicium.

12. Procédé selon la revendication 11, **caractérisé en ce que**, avant l'étape de collage, on forme une couche d'oxyde sur la surface exposée de la deuxième plaque (120).

13. Procédé selon l'une quelconque des revendications 9 à 12, **caractérisé en ce qu'**il comprend, avant l'étape de collage, au moins une étape de réalisation d'une couche de composants (204) sur une face de la première plaque (200), la face de la première plaque (200) comportant la couche de composants (204) étant collée sur la deuxième plaque (300).

14. Procédé selon la revendication 13, **caractérisé en ce qu'**il comprend en outre une étape de réalisation d'une deuxième couche de microcomposants (214) sur la face de la première plaque (200) opposée à la face comportant la première couche de composants (204).

15. Procédé selon la revendication 13 ou 14, **caractérisé en ce qu'**au moins la première couche de composants (214) comporte des capteurs d'images.
